# EUROPÄISCHE PATENTANMELDUNG

(11) **EP 1 315 215 A2**
(43) Veröffentlichungstag der Anmeldung: **28.05.2003**
(21) Anmeldenummer: 02026464.4
(22) Anmeldetag: 27.11.2002
(51) Int. Cl.: H01L 29/788, H01L 29/423, H01L 29/51

(54) **Floatinggate-Feldeffekttransistor**

(30) Priorität: 27.11.2001 DE 10158019
(71) Anmelder: Infineon Technologies AG, 81669 München (DE)
(72) Erfinder: Hofmann, Franz, 80995 München (DE); Rösner, Wolfgang, 85521 Ottobrunn (DE); Specht, Michael, 80799 München (DE); Staedele, Martin, 85521 Ottobrunn (DE)
(74) Vertreter: Viering, Jentschura & Partner

(57) **Zusammenfassung**

Ein vorzugsweise als Speicherzelle verwendeter Floatinggate-Feldeffekttransistor (400) weist oberhalb oder unterhalb eines Floatinggate-Bereichs (407) auf eine elektrisch isolierende Schichtenfolge (408) mit einer unteren Schicht (409) aufweisend eine erste relative Dielektrizitätskonstante, mit einer mittleren Schicht (410) aufweisend eine zweite relative Dielektrizitätskonstante und mit einer oberen Schicht (411) aufweisend eine dritte relative Dielektrizitätskonstante, wobei die zweite relative Dielektrizitätskonstante größer als die erste relative Dielektrizitätskonstante sowie größer als die dritte relative Dielektrizitätskonstante ist.

## Beschreibung

Die Erfindung betrifft einen Floatinggate-Feldeffekttransistor.

Angesichts der rasanten Fortentwicklung in der Computertechnologie besteht Bedarf an Speichermedien, welche immer größere Speichermengen auf immer kleineren Anordnungen mit immer kürzeren Schreib-, Lese- und Löschzeiten bereitstellen. Üblicherweise werden große Datenmengen in einer Anordnung von Speicherzellen gespeichert. Ein Überblick über Speicherzellen gemäß dem Stand der Technik gibt beispielsweise [1] .

Aus [2] ist ein Smartpower-Bauelement genanntes Leistungsbauelement bekannt, das zum sicheren Schalten von induktiven Lasten dient und ein Stromerfassungselement zur Erfassung des Stroms durch die induktive Last aufweist.

Als leistungsfähige Speicherzellen sind einerseits sogenannte dynamische Speicherzellen (DRAM = dynamic random access memory) und andererseits nicht-flüchtige Speicherzellen bekannt.

Eine dynamische Speicherzelle weist einen Auswahltransistor und einen Speicherkondensator auf. Der Auswahltransistor dient dabei dem Auswählen des zugehörigen Speicherkondensators innerhalb einer Speicher-Anordnung auf einem Chip. In Abhängigkeit vom Ladungszustand des Speicherkondensators, d.h. entweder elektrisch geladen oder ungeladen, weist der Speicherkondensator entweder einen Speicherzustand mit einem logischen Wert "0" oder einen Speicherzustand mit einem logischen Wert "1" auf. Da die Kondensatorladung in bekannten Speicherzellen infolge von Rekombinations- und Leckströmen in einer Zeit von ungefähr einer Sekunde abgebaut wird, muss die Ladung immer wieder nachgeliefert werden. Auch nach einem Lesevorgang muss die Information wieder eingeschrieben werden. Dieses Nachliefern von Ladung erfolgt automatisch mit Hilfe einer integrierten Schaltung auf dem Chip. Diese Besonderheit hat dem Speicher den Namen dynamischer Speicher gegeben. Dynamische Speicherzellen weisen vorteilhafter Weise kurze Schreib- und Lesezeiten in der Größenordnung von zehn Nanosekunden auf. Allerdings ist nachteilig, dass dynamische Speicherzellen dauerhaft mit Energie versorgt werden müssen. Dies hat eine hohe Abwärme und damit eine Aufheizung der Speicher-Anordnung zur Folge. Ferner hat eine dynamische Speicherzelle einen hohen Energiebedarf, was den Betrieb von dynamischen Speicherzellen kostenintensiv gestaltet. Dynamische Speicherzellen weisen überdies den Nachteil auf, dass beim Trennen von der Spannungsversorgung die gespeicherten Informationen verloren gehen.

Ein nicht-flüchtiger Speicher (NVM = non volatile memory) zeichnet sich dadurch aus, dass die in der Speicherzelle eingespeicherte Information auch nach dem Abschalten der Versorgungsspannung für eine lange Haltezeit von typischerweise mindestens zehn Jahren erhalten bleibt. Der am häufigsten eingesetzte nicht-flüchtige Halbleiterspeicher ist das EEPROM (EEPROM = electrically erasable and programmable read-only memory). Ein EEPROM gestattet dem Betreiber häufig wiederholbares Lesen, elektrisches Löschen und Programmieren.

Ein wichtiges Beispiel für ein EEPROM ist ein als Speicherzelle ausgebildeter Feldeffekttransistor mit einem sogenannten Floatinggate. Bei dieser Speicherzelle wird die elektrische Ladung in einem Floatinggate, d.h. einer von ihrer Umgebung elektrisch entkoppelten Schicht aus elektrisch leitfähigem Material, gespeichert. Das Umladen des Floatinggates erfolgt mittels tunnelnden Elektronen, welche durch eine elektrisch isolierende Oxidschicht zwischen den Elektrodenbereichen des Feldeffekttransistors und dem Floatinggate hindurch tunneln.

Bei einer Speicherzelle mit Floatinggate tritt an die Stelle des Speicherkondensators des DRAMs der Feldeffekttransistor der Speicherzelle selbst. Beim Programmieren wird an die Wortleitung einer ausgewählten Speicherzelle eine positive elektrische Spannung von typischerweise +10 V bei einer CHE-Zelle (CHE = channel hot electron) und zwischen +15 V und +20 V bei einer FN-Zelle (FN = Fowler-Nordheim) angelegt. Da bei diesen Potentialverhältnissen der ausgewählte Floatinggate-Feldeffekttransistor leitend ist, wird ein n⁺-dotiertes Source-/Drain-Gebiet bzw. der Kanalbereich zwischen den beiden Source-/Drain-Gebieten unterhalb einer Oxidschicht auf ein ausreichend hohes elektrisches Potential gebracht. Dadurch wird die elektrische Feldstärke in der Oxidschicht in die Nähe der Durchbruchfeldstärke von ungefähr 10⁷ V/cm gebracht. Infolgedessen tunneln Elektronen zwischen dem Floatinggate und dem darunter liegenden Source-/Drain-Gebiet bzw. Kanalbereich. Dadurch bleibt im Floatinggate eine nichtkompensierte elektrische Ladung zurück und verbleibt dort für eine lange Haltezeit von typischerweise zehn Jahren. Letzteres auch dann, wenn keine elektrischen Spannungen mehr an dem Floatinggate-Feldeffekttransistor anliegen.

Das EEPROM ist eine besonders platzsparende nicht-flüchtige Speicherzelle, von der im Weiteren zwei Ausführungsformen kurz beschrieben werden. Bei der CHE-Zelle tunneln sogenannte "heiße", d.h. ausreichend energiereiche, Elektronen in der Nähe des Drain-Bereichs durch die Oxidschicht hindurch in das Floatinggate. Dagegen tunneln bei der FN-Zelle die Elektronen auf Grund eines hohen elektrischen Feldes in der Oxidschicht in das Floatinggate. Als Fowler-Nordheim-Tunneln wird der Prozess bezeichnet, bei dem in der Gegenwart eines ausreichend hohen elektrischen Feldes Elektronen durch eine Tunnelschicht hindurch tunneln.

Die Schreib- und Löschzeiten von existierenden EEPROM-Speichern liegen im Bereich zwischen ungefähr einer Millisekunde und ungefähr zehn Mikrosekunden. Damit sind die Schreib- und Löschzeiten von EEPROM-Speichern im Vergleich zu den Schreib- und Löschzeiten von DRAM-Speichern deutlich langsamer. Der Grund hierfür hängt mit der Tunnelbarriere zwischen dem Floatinggate und dem leitenden Kanal zusammen, da eine beispielsweise aus Siliziumdioxid hergestellte Tunnelbarriere eine Mindestdicke von ungefähr zehn Nanometern aufweisen muss, um eine Haltezeit der Speicherzelle von zehn Jahren zu gewährleisten. Dies erfordert hohe Schreib- und Löschspannungen von typischerweise 10 V, teilweise bis zu 20 V. Solche hohen elektrischen Spannungen zum Schreiben bzw. Löschen sind nachteilig, da Elemente in integrierten Schaltkreisen von zu hohen elektrischen Spannungen negativ beeinflusst und sogar zerstört werden können.

Im Weiteren werden drei aus der Literatur bekannte Konzepte beschrieben, deren Gegenstand es ist, Speicherzellen mit kurzen Schreib- bzw. Löschzeiten bereitzustellen, wobei die Speicherzellen Haltezeiten in der Größenordnung von zehn Jahren aufweisen.

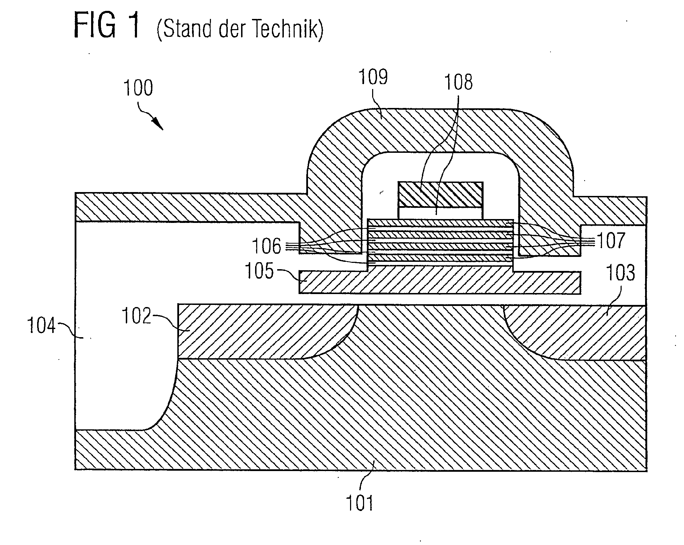

Bezugnehmend auf **Fig.1** wird im Folgenden das Prinzip der sogenannten PLED-Speicherzelle 100 (PLED = planar localized electron device) beschrieben, welches aus [3] bekannt ist.

Die in Fig.1 dargestellte PLED-Speicherzelle 100 weist ein Substrat 101, einen Source-Bereich 102 in einem ersten Oberflächenbereich des Substrats 101 und einen Drain-Bereich 103 in einem zweiten Oberflächenbereich des Substrats 101 auf. Mittels eines elektrisch isolierenden Bereichs 104, welcher in dem Bereich zwischen dem Source-Bereich 102 und dem Drain-Bereich 103 die Funktion einer Gateoxid-Schicht erfüllt, ist das Substrat 101 mit den darin eingebrachten Source- und Drain-Bereichen 102, 103 von einem Ladungsspeicher-Bereich 105 getrennt. Oberhalb des Ladungsspeicher-Bereichs 105 ist eine Mehrzahl von Doppelschichten angeordnet, wobei jede der Doppelschichten alternierend eine Tunnelschicht 106 und einen halbleitenden Bereich 107 aus intrinsischem Silizium aufweist. Die dargestellte PLED-Speicherzelle 100 weist vier Doppelschichten aus jeweils einer Tunnelschicht 106 und einem halbleitenden Bereich 107 auf. Oberhalb der Anordnung von Doppelschichten ist eine Elektrode 108 angebracht. An den Seitenrändern der Doppelschichten sind diese von einer seitlichen Gate-Elektrode 109 mittels einer dünnen Oxidschicht getrennt, die als Teil des elektrisch isolierenden Bereichs 104 ausgebildet ist.

Die PLED-Speicherzelle 100 kann als Datenspeicher verwendet werden. Dabei wird der Effekt ausgenützt, dass gegebenenfalls in den Ladungsspeicher-Bereich 105 eingebrachte elektrische Ladungsträger die elektrische Leitfähigkeit des Kanals zwischen dem Source-Bereich 102 und dem Drain-Bereich 103 charakteristisch beeinflussen. Sind in dem Ladungsspeicher-Bereich 105 elektrische Ladungsträger eingebracht, so weist der Kanal zwischen dem Source-Bereich 102 und dem Drain-Bereich 103 eine erste elektrische Leitfähigkeit auf. Eine zwischen dem Source-Bereich 102 und dem Drain-Bereich 103 angelegte Spannung führt dann zu einem Stromfluss einer ersten Stromstärke zwischen dem Source-Bereich 102 und dem Drain-Bereich 103. Ist dagegen der Ladungsspeicher-Bereich 105 von elektrischen Ladungsträgern frei, so weist der Kanal zwischen dem Source-Bereich 102 und dem Drain-Bereich 103 eine zweite elektrische Leitfähigkeit auf, die von der ersten elektrischen Leitfähigkeit deutlich verschieden ist. Außerdem bewirkt eine zwischen dem Source-Bereich 102 und dem Drain-Bereich 103 angelegte elektrische Spannung einen elektrischen Stromfluss einer zweiten Stromstärke, wobei die zweite Stromstärke deutlich verschieden von der ersten Stromstärke ist.

Ist an die seitliche Gate-Elektrode 109 eine elektrische Spannung nicht angelegt, so sind die Doppelschichten aus den Tunnelschichten 106 und den halbleitenden Bereichen 107 elektrisch isolierend, so dass gegebenenfalls in dem Ladungsspeicher-Bereich 105 eingebrachte Ladungsträger dort dauerhaft gespeichert sind. Mittels Anlegen einer geeigneten elektrischen Spannung an die seitliche Gate-Elektrode 109 wird an den linken und rechten Rändern der Tunnelschichten 106 jeweils ein elektrisch leitfähiger Bereich ausgebildet. In diesem Zustand sind die Doppelschichten aus den Tunnelschichten 106 und den halbleitenden Bereichen 107 elektrisch gut leitfähig. Wird in diesem Zustand an die Elektrode 108 eine weitere elektrische Spannung angelegt, so können Ladungsträger von der Elektrode 108 auf den Ladungsspeicher-Bereich 105 fließen oder umgekehrt. Nach Abschalten der an die seitliche Gate-Elektrode 109 angelegten elektrischen Spannung wird die Doppelschicht aus der Tunnelschicht 106 und den halbleitenden Bereichen 107 wieder elektrisch isolierend, so dass gegebenenfalls in dem Ladungsspeicher-Bereich 105 eingespeicherte Ladungsträger dort dauerhaft verbleiben. Das schnelle Schreiben und Löschen wird gemäß der PLED-Speicherzelle 100 also dadurch-erreicht, dass die Seitenbereiche einer mehrfachen Tunnelbarriere mittels seitlichen Anlegens einer zusätzlichen elektrischen Spannung elektrisch leitfähig gemacht werden.

Allerdings ist sowohl die Herstellung als auch der Betrieb einer PLED-Speicherzelle aufwändig, da einerseits die PLED-Speicherzelle mit vier Elektroden zu realisieren ist und andererseits die vier Elektroden der PLED-Speicherzelle in der Speicheranordnung mit entsprechenden Leiterbahnen elektrisch zu koppeln sind. Dabei sind jedoch die vier Elektroden nicht in einfacher Planartechnik herstellbar. Folglich sind PLED-Speicherzellen aufwändig und teuer.

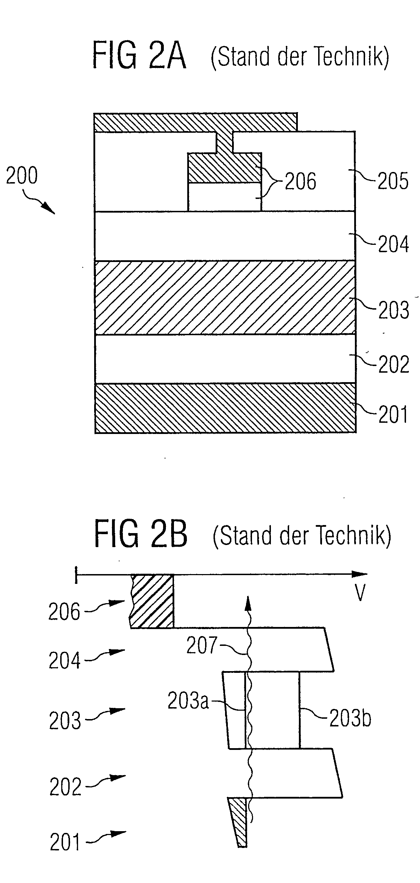

Bezugnehmend auf **Fig.2a** und **Fig.2b** wird im Weiteren das Konzept einer Resonanz-Tunneldiode 200 beschrieben, welches aus [4] bekannt ist und in erweiterter Form als Tunneldielektrikum eingesetzt werden kann.

Die in Fig.2a dargestellte Resonanz-Tunneldiode 200 weist ein n⁺-dotiertes Silizium-Substrat 201, eine erste Tunnelbarriere 202, eine Potentialtopf-Schicht 203, eine zweite Tunnelbarriere 204, eine elektrisch isolierende Schicht 205 und eine Elektrode 206 auf. Die Elektrode 206 ist gemäß der in Fig.2a dargestellten Resonanz-Tunneldiode 200 eine Struktur aus Aluminium und Gold. Die erste Tunnelbarriere 202 ist aus Kalziumdifluorid (CaF₂) hergestellt, die Potentialtopf-Schicht 203 ist aus Cadmiumdifluorid (CdF₂) hergestellt, und die zweite Tunnelbarriere 204 ist wiederum aus Kalziumdifluorid (CaF₂) hergestellt.

In Fig.2b sind die Potentialverhältnisse (horizontal aufgetragen ist das elektrische Potential V) entlang der Resonanz-Tunneldiode 200 (deren Struktur ist vertikal aufgetragen) dargestellt.

Insbesondere weist die Potentialtopf-Schicht 203 zwei Energieniveaus 203a, 203b auf, welche derart vorgesehen sind, dass in Abwesenheit einer elektrischen Spannung zwischen dem n⁺-dotierten Silizium-Substrat 201 und der Elektrode 206 ein elektrischer Stromfluss durch die Potentialtopf-Schicht 203 hindurch nicht möglich ist. Ist dagegen, wie in Fig.2b dargestellt, eine geeignete elektrische Spannung zwischen dem n⁺-dotierten Silizium-Substrat 201 und der Elektrode 206 angelegt, so befindet sich das erste Energieniveau 203a der Potentialtopf-Schicht 203 auf einem solchen elektrischen Potential, dass ein elektrischer Stromfluss von dem n⁺-dotierten Silizium-Substrat 201 durch die Potentialtopf-Schicht 203 hindurch bis hinein in die Elektrode 206 ermöglicht ist. Dies ist in Fig.2b mittels eines Pfeils 207 veranschaulicht.

Resonanz-Tunneldioden ermöglichen es zwar, das als Tunneldielektrikum verwendete Siliziumdioxid (SiO₂) zu ersetzen, haben jedoch den Nachteil, dass in sie keine steuerbaren Leistungsbauelemente integriert sind.

Aus [5] ist das Konzept der sogenannten "Crested-Barrier" bekannt. Gemäß diesem Konzept wird eine serielle Anordnung von typischerweise drei Tunnelbarrieren mit unterschiedlichen energetischen Höhen der Potential-Barrieren an Stelle der Oxidschicht zwischen leitendem Kanal und Floatinggate eines Floatinggate-Feldeffekttransistors verwendet. Bei den oben beschriebenen herkömmlichen EEPROM-Speichern ist die Oxidschicht zwischen leitendem Kanal und Floatinggate üblicherweise eine ungefähr zehn Nanometer dicke Siliziumdioxid-Schicht mit einer homogenen Struktur. Theoretische Überlegungen zeigen, dass eine gleichdicke Barriere, die keinen rechteckförmigen, sondern einen zumindest näherungsweise stufenförmigen elektrischen Potentialverlauf mit der höchsten Potentialbarriere in der Mitte aufweist, ein beschleunigtes Schreiben bzw. Löschen bei gleichbleibender Haltezeit ermöglicht. Dies liegt daran, dass mit näherungsweise stufenförmigem elektrischem Potentialverlauf die zum Schreiben bzw. Löschen benötigte Spannung deutlich geringer sein kann als bei rechteckförmigem elektrischem Potentialverlauf.

Der Grundgedanke des "Crested-Barrier"-Konzepts besteht dabei darin, das Verhältnis der Tunnelstromstärke durch eine Tunnelschicht bei angelegter Schreib- bzw. Löschspannung zu der Tunnelstromstärke bei angelegter halber Schreib- bzw. Löschspannung für eine Tunnelbarriere mit rechteckigem Potentialverlauf und für eine Tunnelbarriere mit stufenförmigem Potentialverlauf mit höchster Potentialbarriere in der Mitte zu vergleichen. Es zeigt sich, dass dieses Tunnelstromverhältnis für eine stufenförmige Potentialbarriere mit höchster Potentialbarriere in der Mitte erheblich größer ist als für eine rechteckförmige Barriere. Dieses Tunnelstromverhältnis ist ein Maß für das Verhältnis zwischen der Haltezeit und der Löschzeit bzw. für das Verhältnis zwischen der Haltezeit und der Programmierzeit einer auf dem "Crested-Barrier"-Konzept basierenden Speicherzelle.

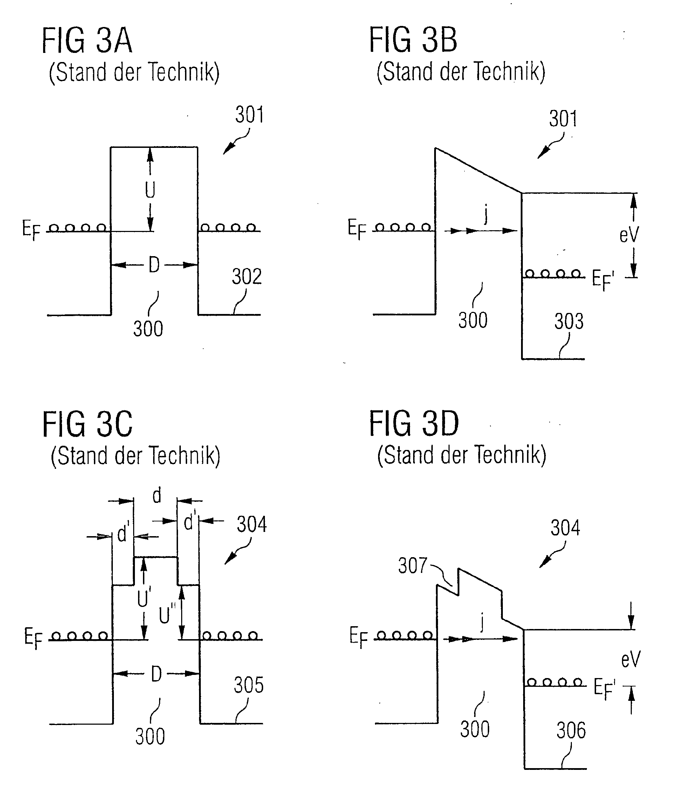

Ein stufenförmiger Potentialverlauf mit höchster Potentialbarriere in der Mitte kann gemäß [5] mittels dreier dünner Schichten angenähert werden, wobei die mittlere Schicht eine höhere Potentialbarriere aufweist als die beiden Randschichten. Ein rechteckiger Potentialverlauf 301 einer Tunnelbarriere 300 ist in **Fig.3a** im Grundzustand 302 und **Fig.3b** im verspannten Zustand 303 und ein stufenförmiger Potentialverlauf 304 einer Tunnelbarriere ist in **Fig.3c** im Grundzustand 305 und **Fig.3d** im verspannten Zustand 306 dargestellt. Die Tunnelbarriere 300 weist eine Dicke D und eine Potentialhöhe U gegenüber dem Fermi-Niveau E_{F} der Tunnelbarriere 300 auf. Bei einem mittels dreier dünner Schichten verwirklichten stufenförmigen Potentialverlauf 304 weist die mittlere Schicht eine Dicke d und gegenüber dem Fermi-Niveau E_{F} eine hohe Potentialbarriere U' auf, während die beiden äußeren Schichten jeweils eine Dicke d' und gegenüber dem Fermi-Niveau E_{F} eine niedrige Potentialbarriere U" aufweisen. Dabei beträgt die Dicke d der mittleren Schicht üblicherweise mehr als 3 nm, um eine sichere Isolationswirkung der Tunnelbarriere zu gewährleisten.

Solange der Potentialverlauf der Tunnelbarriere 300 im Grundzustand 302 bzw. 305 vorliegt, findet zwischen den beiden Schichten, welche in den Figuren links und rechts an die Tunnelbarriere 300 angrenzen, kein Ladungsträgeraustausch statt, da der Tunnelstrom bzw. die Tunnelwahrscheinlichkeit zu gering ist. Wenn der Potentialverlauf der Tunnelbarriere 300 mittels einer an der Schicht, welche sich rechts von der Tunnelbarriere 300 befindet, anliegenden äußeren Potentialdifferenz V vorgespannt wird, kommt es zu einer Verschiebung des Potentialverlaufs. Dabei wird das Fermi-Niveau E_{F} der rechts an die Tunnelbarriere 300 angrenzenden Schicht um die Energiedifferenz eV auf ein verspanntes Fermi-Niveau E_{F}' abgesenkt. Dadurch wird ein Tunneln von Elektronen durch die Tunnelbarriere 300 hindurch ermöglicht. Dies hat folglich einen Austausch von Ladungsträgern in Form eines elektrischen Stromes j zwischen den an die Tunnelbarriere 300 angrenzenden Schichten zur Folge. Dieser Strom j fließt wegen der Energiedifferenz eV von der Seite der Tunnelbarriere 300 mit dem höheren Fermi-Niveau E_{F} zu der Seite der Tunnelbarriere 300 mit dem niedrigeren, verspannten Fermi-Niveau E_{F}'.

Dabei zeigt sich, dass für den beschriebenen stufenförmigen Potentialverlauf mit höchster Potentialbarriere in der Mitte die Stromdichte von Fowler-Nordheim-Tunneln wesentlich empfindlicher von einer angelegten Spannung abhängig ist als für einen rechteckförmigen Potentialverlauf.

Allerdings hat der stufenförmige Potentialverlauf mit höchster Potentialbarriere in der Mitte aus dem "Crested-Barrier"-Konzept den Nachteil, dass beim Anliegen einer Potentialdifferenz zwischen den beiden Enden der Tunnelbarrieren-Schicht diese derart verspannt wird, dass an der mittleren Schicht der Tunnelbarriere eine Ladungsträgersenke 307 gebildet wird. In der Ladungsträgersenke 307 werden Ladungsträger akkumuliert, da diese wegen der Dicke der mittleren Schicht nicht durch diese hindurch tunneln können. Diese Ladungsträger-Akkumulation in der Ladungsträgersenke 307 kann jedoch zu einer unerwünschten Veränderung der elektronischen Eigenschaften eines "Crested-Barrier"-Feldeffekttransistors führen. Insbesondere eignet sich das "Crested-Barrier"-Konzept nur begrenzt für niedrige Spannungen von kleiner als +10 V.

Der Erfindung liegt somit das Problem zugrunde, einen Floatinggate-Feldeffekttransistor als nicht-flüchtigen Datenspeicher mit gegenüber dem Stand der Technik verkürzten Schreib- und Löschzeiten bei im Wesentlichen zumindest gleichbleibend langen Haltezeiten bereitzustellen.

Das Problem wird durch einen Floatinggate-Feldeffekttransistor mit den Merkmalen gemäß dem unabhängigen Patentanspruch gelöst.

Ein Floatinggate-Feldeffekttransistor weist auf einen Source-Bereich, einen Drain-Bereich und einen Kanalbereich, eine über dem Kanalbereich angeordnete erste elektrische Isolationsschicht, einen über der ersten elektrischen Isolationsschicht angeordneten Floatinggate-Bereich, eine über dem Floatinggate-Bereich angeordnete zweite elektrische Isolationsschicht, und einen über der zweiten elektrischen Isolationsschicht angeordneten Gate-Bereich. Die erste elektrische Isolationsschicht oder die zweite elektrische Isolationsschicht weist eine elektrisch isolierende Schichtenfolge aus drei Schichten auf. Diese elektrisch isolierende Schichtenfolge weist eine untere Schicht aus einem Material mit einer ersten relativen Dielektrizitätskonstante, eine mittlere Schicht aus einem Material mit einer zweiten relativen Dielektrizitätskonstante und eine obere Schicht aus einem Material mit einer dritten relativen Dielektrizitätskonstante auf. Dabei ist die zweite relative Dielektrizitätskonstante größer als die erste relative Dielektrizitätskonstante sowie größer als die dritte relative Dielektrizitätskonstante.

Anschaulich kann die elektrisch isolierende Schichtenfolge des Floatinggate-Feldeffekttransistors folglich als Tripel-Tunnelbarriere angesehen werden.

Ein Vorteil der Erfindung ist darin zu sehen, dass der Floatinggate-Feldeffekttransistor ein Speicherelement darstellt, welches als Tunnelbarriere zum Floatinggate-Bereich eine spezielle, elektrisch isolierende Schichtenfolge aufweist. Die elektrisch isolierende Schichtenfolge ist materialtechnisch derart vorgesehen, dass sich in der Tunnelbarriere anschaulich ein stufenförmiger Potentialverlauf ausbildet, wobei die mittlere Schicht eine niedrigere Potentialbarriere aufweist als die untere Schicht und zugleich als die obere Schicht. Dieser stufenförmige Potentialverlauf kann anschaulich auch als Potentialtopf angesehen werden. Dies ist eine direkte Folge der geeigneten Materialwahl und somit der jeweiligen relativen Dielektrizitätskonstante für die einzelnen Schichten der elektrisch isolierenden Schichtenfolge.

Beim Anlegen einer äußeren Potentialdifferenz V an das Floatinggate wird der stufenförmige Potentialverlauf der elektrisch isolierenden Schichtenfolge um eine Energie eV verspannt. Dabei wird die niedrigere Potentialbarriere der mittleren Schicht unter das Fermi-Niveau E_{F} abgesenkt. Wird das Fermi-Niveaus E_{F}, welches beispielsweise an die obere Schicht der elektrisch isolierenden Schichtenfolge angrenzt, um die Energie eV auf das verspannte Fermi-Niveau E_{F}' abgesenkt, wird auch die Potentialbarriere der oberen Schicht unter das Fermi-Niveau E_{F} abgesenkt. Folglich verbleibt lediglich die Potentialbarriere der unteren Schicht oberhalb des Fermi-Niveaus E_{F}. Zum Erreichen eines Stromflusses aus dem Fermi-Niveau E_{F} unterhalb der elektrisch isolierenden Schichtenfolge in das verspannte Fermi-Niveau E_{F}' oberhalb der elektrisch isolierenden Schichtenfolge müssen Elektronen aus dem Fermi-Niveau E_{F} lediglich durch die Potentialbarriere der unteren Schicht hindurch tunneln. Somit wird erreicht, dass im verspannten Zustand die effektiv zu durchtunnelnde Dicke der elektrisch isolierenden Schichtenfolge kleiner als die Dicke einer durchgängig homogenen elektrischen Isolationsschicht mit rechteckigem, d.h. linearem, Potentialverlauf ist. Dies hat zur Folge, dass bei gleichbleibend langer Haltezeit bei der elektrisch isolierenden Schichtenfolge die Stromdichte erhöht werden kann und somit die Schreib- und Löschzeiten verkürzt werden können.

Die effektiv wirksame Dicke (EOT = equivalent oxide thickness) der elektrisch isolierenden Schichtenfolge im spannungsfreien Zustand kann aus der physikalischen Dicke sowie den relativen Dielektrizitätskonstanten der in der elektrisch isolierenden Schichtenfolge verwendeten Materialien berechnet werden und wird zum Vergleichen mit der Dicke einer durchgängig homogenen elektrischen Isolationsschicht mit linearem Potentialverlauf verwendet. Beispielsweise errechnet sich für eine Schicht aus Siliziumnitrid (Si₃N₄) mit einer physikalischen Dicke d von 3,8 nm, einer relativen Dielektrizitätskonstante ε₁ von 7,8 für Siliziumnitrid (Si₃N₄) und einer relativen Dielektrizitätskonstante ε₂ von 4 für Siliziumoxid (SiO₂) gemäß d_{EOT} = ε₂/ε₁·d eine effektiv wirksame Breite d_{EOT} von 1,9 nm. Folglich weist eine elektrisch isolierende Schichtenfolge aus einer 1 nm dicken Schicht aus Siliziumdioxid (SiO₂), einer 3,8 nm dicken Schicht aus Siliziumnitrid (Si₃N₄) und einer 1 nm dicken Schicht aus Siliziumdioxid (SiO₂) eine effektiv wirksame Gesamtdicke von 3,9 nm auf.

Ein weiterer Vorteil des Floatinggate-Feldeffekttransistors ist, dass mittels des stufenförmigen Potentialverlaufs mit niedrigerer Potentialbarriere in der Mitte das Ausbilden einer Ladungsträgersenke wie beispielsweise gemäß dem "Crested-Barrier"-Konzept verhindert wird. Auf Grund der angegebenen Materialwahl können sowohl die untere Schicht als auch die obere Schicht der elektrisch isolierenden Schichtenfolge ausreichend dünn gewählt werden, so dass im verspannten Zustand Ladungsträger weitgehend ungehindert durch die untere Schicht und die obere Schicht hindurch tunneln können. Somit werden keine Ladungsträger, welche im verspannten Zustand durch die elektrisch isolierende Schichtenfolge hindurch tunneln, akkumuliert. Dies hat weiterhin zur Folge, dass die elektronischen Eigenschaften des Floatinggate-Feldeffekttransistors unbeeinflusst bleiben.

Anschaulich ist der Floatinggate-Feldeffekttransistor also derart eingerichtet, dass beim Anliegen eines elektrischen Feldes in der elektrisch isolierenden Schichtenfolge keine Ladungsträger-Akkumulation erfolgt.

Die untere Schicht und die obere Schicht des Floatinggate-Feldeffekttransistors weisen bevorzugt eine zwischen 0,5 eV und 1,5 eV höhere Potentialbarriere als die mittlere Schicht auf.

Vorzugsweise weisen bei dem Floatinggate-Feldeffekttransistor die erste relative Dielektrizitätskonstante und die dritte relative Dielektrizitätskonstante jeweils einen Wert im Bereich zwischen 1 und 10 auf, und die zweite relative Dielektrizitätskonstante weist bevorzugt einen Wert im Bereich zwischen 10 und 25 auf.

In einer bevorzugten Ausführungsform des Floatinggate-Feldeffekttransistors sind in der elektrisch isolierenden Schichtenfolge die untere Schicht und die obere Schicht aus dem gleichen Material hergestellt.

Die untere Schicht sowie die obere Schicht der elektrisch isolierenden Schichtenfolge des Floatinggate-Feldeffekttransistors weisen vorzugsweise jeweils eine Dicke im Bereich von 0,5 nm bis 2 nm auf. Die mittlere Schicht der elektrisch isolierenden Schichtenfolge des Floatinggate-Feldeffekttransistors weist bevorzugt eine Dicke im Bereich von 5 nm bis 10 nm auf. Dadurch wird die notwendige Spannung zum Programmieren bzw. Löschen des Floatinggate-Bereichs des Floatinggate-Feldeffekttransistors auf weniger als 8 V reduziert. Ebenfalls reduziert sich die notwendige Schreibzeit zum Programmieren bzw. Löschen des Floatinggate-Bereichs von einigen Mikrosekunden auf weniger als zehn Nanosekunden. Insbesondere für niedrige Spannungen ist das erfindungsgemäße Konzept im Vergleich zum "Crested-Barrier"-Konzept somit vorteilhafter.

In einer bevorzugten Ausführungsform des Floatinggate-Feldeffekttransistors weisen die untere Schicht sowie die obere Schicht der elektrisch isolierenden Schichtenfolge jeweils Siliziumdioxid (SiO₂) sowie eine Dicke von 1 nm auf, während die mittlere Schicht der elektrisch isolierenden Schichtenfolge Zirkonoxid (ZrO₂) sowie eine Dicke von 6 nm aufweist. Schichten mit einer Dicke von 1 nm können dabei beispielsweise mittels der sogenannten Atomlagenabscheidung (ALD = atomic layer deposition) erzeugt werden. Statt Siliziumdioxid (SiO₂) für die obere Schicht und die untere Schicht können auch beispielsweise Aluminiumoxid (Al₂O₃), Lanthanoxid (La₂O₃), Yttriumoxid (Y₂O₃) oder Siliziumnitrid (Si₃N₄) verwendet werden. Statt Zirkonoxid (ZrO₂) für die mittlere Schicht kann auch beispielsweise Hafniumoxid (HfO₂), Siliziumnitrid (Si₃N₄) oder eine sogenanntes Aluminat verwendet werden. Als Aluminat wird eine Mischstruktur aus Aluminiumoxid (Al₂O₃) und einem anderen Oxid eines Materials mit hoher relativer Dielektrizitätskonstante bezeichnet.

Ausführungsbeispiele der Erfindung sind in den Figuren dargestellt und werden im Folgenden näher erläutert. Dabei bezeichnen gleiche Bezugszeichen gleiche Komponenten.

Es zeigen
- Figur 1: das Prinzip einer PLED-Speicherzelle gemäß dem Stand der Technik;
- Figur 2a: eine Resonanz-Tunneldiode gemäß dem Stand der Technik;
- Figur 2b: die Potentialverhältnisse entlang der Resonanz-Tunneldiode gemäß dem Stand der Technik;
- Figur 3a: einen rechteckigen Potentialverlauf im Grundzustand für eine Isolationsschicht zwischen Floatinggate und Transistorelektroden gemäß dem Stand der Technik;
- Figur 3b: einen rechteckigen Potentialverlauf im verspannten Zustand für die Isolationsschicht zwischen Floatinggate und Transistorelektroden gemäß dem Stand der Technik;
- Figur 3c: einen stufenförmigen Potentialverlauf mit höchster Potentialbarriere in der Mitte im Grundzustand für die Isolationsschicht zwischen Floatinggate und Transistorelektroden gemäß dem Stand der Technik;
- Figur 3d: einen stufenförmigen Potentialverlauf mit höchster Potentialbarriere in der Mitte im verspannten Zustand für die Isolationsschicht zwischen Floatinggate und Transistorelektroden gemäß dem Stand der Technik;
- Figur 4: einen schematischen Querschnitt durch einen Floatinggate-Feldeffekttransistor gemäß einem ersten Ausführungsbeispiel der Erfindung;
- Figur 5a: einen stufenförmigen Potentialverlauf mit niedrigerer Potentialbarriere in der Mitte im Grundzustand für die zweite elektrische Isolationsschicht des Floatinggate-Feldeffekttransistors gemäß Fig.4;
- Figur 5b: einen stufenförmigen Potentialverlauf mit niedrigerer Potentialbarriere in der Mitte im verspannten Zustand für die zweite elektrische Isolationsschicht des Floatinggate-Feldeffekttransistors gemäß Fig.4;
- Figur 6: einen schematischen Querschnitt durch einen Floatinggate-Feldeffekttransistor gemäß einem zweiten Ausführungsbeispiel der Erfindung; und
- Figur 7: ein Diagramm mit Stromdichte-Spannungs-Kennlinien für drei verschiedene Arten von elektrischen Isolationsschichten für einen Floatinggate-Feldeffekttransistor.

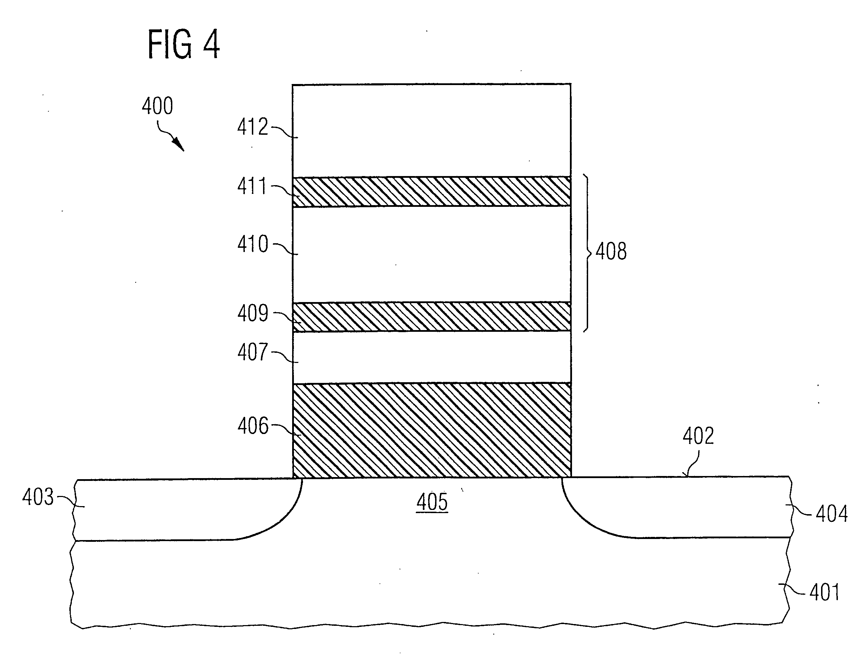

**Fig.4** zeigt einen schematischen Querschnitt durch einen Floatinggate-Feldeffekttransistor 400 gemäß einem ersten Ausführungsbeispiel der Erfindung.

Der Floatinggate-Feldeffekttransistor 400 gemäß diesem Ausführungsbeispiel basiert auf einem Halbleitersubstrat 401 aus Silizium. In dem Halbleitersubstrat 401 sind an einer Substratoberfläche 402 ein n⁺-dotierter Source-Bereich 403 und ein n⁺-dotierter Drain-Bereich 404 angeordnet, welche räumlich durch einen zwischen diesen angeordneten Kanalbereich 405 voneinander getrennt sind. Auf der Substratoberfläche 402 ist über dem Kanalbereich 405 eine erste elektrische Isolationsschicht 406 aufgebracht. Die erste elektrische Isolationsschicht 406 weist gemäß diesem Ausführungsbeispiel Siliziumdioxid (SiO₂) mit einer Dicke von 10 nm auf.

Über der ersten elektrischen Isolationsschicht 406 ist ein Floatinggate-Bereich 407 angeordnet, welcher ein beliebiges elektrisch leitfähiges Material aufweisen kann. Darüber ist eine zweite elektrische Isolationsschicht 408 angeordnet, welche sich aus den folgenden drei Teilschichten zusammensetzt: Über dem Floatinggate-Bereich 407 sind zunächst eine untere Schicht 409, darüber eine mittlere Schicht 410 und dann eine obere Schicht 411 angeordnet. Die untere Schicht 409 und die obere Schicht 411 weisen gemäß diesem Ausführungsbeispiel jeweils Siliziumdioxid (SiO₂) mit einer Dicke von jeweils 1 nm auf. Diese beiden Schichten werden gemäß diesem Ausführungsbeispiel mittels Atomlagenabscheidung (ALD = atomic layer deposition) abgeschieden. Die mittlere Schicht 410 weist gemäß diesem Ausführungsbeispiel Zirkonoxid (ZrO₂) mit einer Dicke von 6 nm auf. Somit weist die zweite elektrische Isolationsschicht 408 eine physikalische Gesamtdicke d von 8 nm auf. Der Wert der relativen Dielektrizitätskonstante von Zirkonoxid (ZrO₂) wird auf 25 festgelegt. Daraus resultiert wegen d_{EOT} = ε₂/ε₁·d für die zweite elektrische Isolationsschicht 408 eine effektiv wirksame Gesamtdicke von rund 3,0 nm.

Über der zweiten elektrischen Isolationsschicht 408 ist abschließend eine Gate-Elektrode 412 aufgebracht, welche gemäß diesem Ausführungsbeispiel aus Polysilizium besteht. Das Einspeichern bzw. Löschen des Floatinggate-Bereichs 407 erfolgt gemäß diesem Ausführungsbeispiel von der Gate-Elektrode 412 her durch die zweite elektrische Isolationsschicht 408 hindurch. Auf Grund der geringeren Dicke der zweiten elektrischen Isolationsschicht 408 im Vergleich zu einer homogenen Isolationsschicht aus Siliziumdioxid (SiO₂) mit gleicher Isolationswirkung kann die notwendige Programmier- bzw. Löschspannung auf weniger als 8 V und die benötigte Schreibzeit auf weniger als 10 ns reduziert werden.

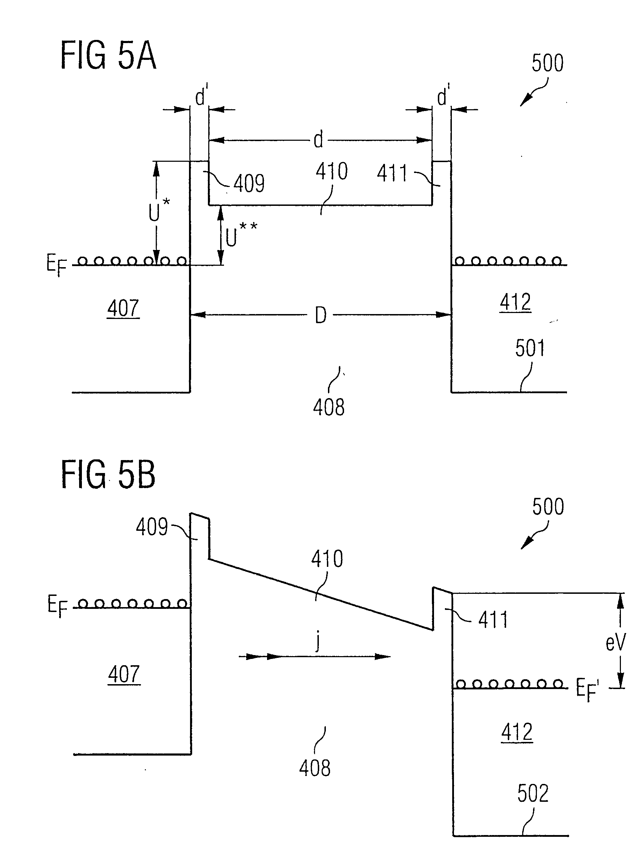

In **Fig.5a** ist ein stufenförmiger Potentialverlauf 500 mit niedrigerer Potentialbarriere in der Mitte im Grundzustand 501 für die zweite elektrische Isolationsschicht 408 des Floatinggate-Feldeffekttransistors 400 gemäß Fig.4 dargestellt.

Für den Floatinggate-Bereich 407 und die Gate-Elektrode 412 des Floatinggate-Feldeffekttransistors 400 ist jeweils das Fermi-Niveau E_{F} eingezeichnet. Die zweite elektrische Isolationsschicht 408 weist, wie in der Beschreibung zu Fig.4 bereits erläutert, eine Gesamtdicke D von 8 nm auf und setzt sich aus der unteren Schicht 409, der mittleren Schicht 410 und der oberen Schicht 411 zusammen. Die untere Schicht 409 und die obere Schicht 411 der zweiten elektrischen Isolationsschicht 408 haben jeweils eine Dicke d' von 1 nm und weisen bezüglich des Fermi-Niveaus E_{F} des Floatinggate-Bereichs 407 bzw. der Gate-Elektrode 412 eine hohe Potentialbarriere U* auf. Die mittlere Schicht 410 hat eine Dicke d von 6 nm und weist bezüglich des Fermi-Niveaus E_{F} des Floatinggate-Bereichs 407 bzw. der Gate-Elektrode 412 eine niedrige Potentialbarriere U** auf, welche zwischen 0,5 eV und 1,5 eV niedriger ist als die hohe Potentialbarriere U*.

**Fig.5b** zeigt einen stufenförmigen Potentialverlauf 500 mit niedrigerer Potentialbarriere in der Mitte im verspannten Zustand 502 für die zweite elektrische Isolationsschicht 408 des Floatinggate-Feldeffekttransistors 400 gemäß Fig.4.

Wird nun zwischen den Floatinggate-Bereich 407 und die Gate-Elektrode 412 des Floatinggate-Feldeffekttransistors 400 eine Potentialdifferenz V angelegt, so resultiert aus dem Fermi-Niveau EF der Gate-Elektrode 412 ein um die Energiedifferenz eV verringertes, verspanntes Fermi-Niveau E_{F}'. Dadurch können Ladungsträger in Form eines elektrischen Stromes j aus dem Floatinggate-Bereich 407 durch die zweite elektrische Isolationsschicht 408 hindurch in die Gate-Elektrode 412 tunneln.

Zum Einspeichern von Ladungsträgern in den Floatinggate-Bereich 407 wird eine Potentialdifferenz V derartig zwischen den Floatinggate-Bereich 407 und die Gate-Elektrode 412 des Floatinggate-Feldeffekttransistors 400 angelegt, dass aus dem Fermi-Niveau E_{F} des Floatinggate-Bereichs 407 ein um die Energiedifferenz eV verringertes, verspanntes Fermi-Niveau E_{F'} resultiert. Damit ergibt sich dann ein zum elektrischen Strom j entgegengesetzter Stromfluss, wodurch Ladungsträger aus der Gate-Elektrode 412 in den Floatinggate-Bereich 407 tunneln.

Auf Grund der Struktur der Schichtenfolge in der zweiten elektrischen Isolationsschicht 408, insbesondere auf Grund der geringen Dicke d' der unteren Schicht 409 und der oberen Schicht 411 von jeweils lediglich 1 nm, kommt es in der mittleren Schicht 410 zu keiner Ladungsträger-Akkumulation. Somit führt das Tunneln von Ladungsträgern durch die Schichtenfolge der zweiten elektrischen Isolationsschicht 408 zu keiner Veränderung der elektronischen Eigenschaften des Floatinggate-Feldeffekttransistors 400.

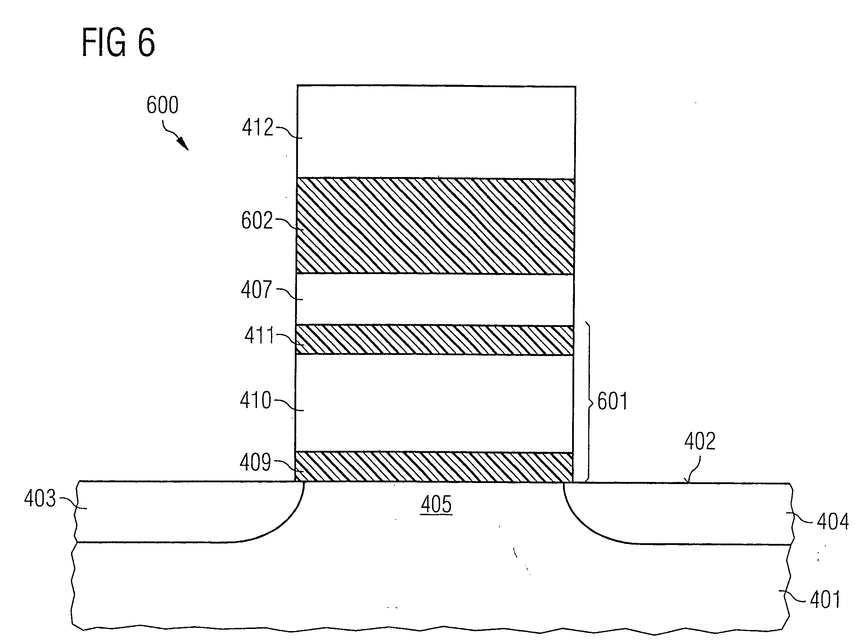

In **Fig.6** ist ein schematischer Querschnitt durch einen Floatinggate-Feldeffekttransistor 600 gemäß einem zweiten Ausführungsbeispiel der Erfindung dargestellt.

Der Floatinggate-Feldeffekttransistor 600 gemäß dem zweiten Ausführungsbeispiel ist eine Alternative zum Floatinggate-Feldeffekttransistor 400 gemäß dem ersten Ausführungsbeispiel. Im Unterschied zum Floatinggate-Feldeffekttransistor 400 gemäß dem ersten Ausführungsbeispiel sind bei dem Floatinggate-Feldeffekttransistor 600 gemäß dem zweiten Ausführungsbeispiel die beiden Isolationsschichten, welche den Floatinggate-Bereich 407 nach oben bzw. unten begrenzen, vertauscht. Die Schichtenfolge aus der unteren Schicht 409, der mittleren Schicht 410 und der oberen Schicht 411 ist gemäß dem zweiten Ausführungsbeispiel auf der Substratoberfläche 402 über dem Kanalbereich 405 als erste elektrische Isolationsschicht 601 unter dem Floatinggate-Bereich 407 aufgebracht. Die untere Schicht 409 und die obere Schicht 411 weisen gemäß diesem Ausführungsbeispiel jeweils Siliziumdioxid (SiO₂) mit einer Dicke von jeweils 1 nm auf. Die mittlere Schicht 410 weist gemäß diesem Ausführungsbeispiel Zirkonoxid (ZrO₂) mit einer Dicke von 6 nm auf.

Die Positionierung der Schichtenfolge aus der unteren Schicht 409, der mittleren Schicht 410 und der oberen Schicht 411 zwischen Kanalbereich 405 und Floatinggate-Bereich 407 hat den Vorteil, dass die untere Schicht 409 mittels thermischer Oxidation der Substratoberfläche 402 erzeugt werden kann und somit eine ideale Grenzfläche zwischen dem Kanalbereich 405 und der unteren Schicht 409 resultiert.

Die obere Schicht 411 wird gemäß diesem Ausführungsbeispiel mittels Atomlagenabscheidung (ALD = atomic layer deposition) abgeschieden. Daraus ergibt sich für die erste elektrische Isolationsschicht 601 eine Gesamtdicke von 8 nm, welche um 25% schmäler als eine gleichwertige homogene Isolationsschicht aus Siliziumdioxid (SiO₂) ist. Die zweite elektrische Isolationsschicht 602 zwischen Floatinggate-Bereich 407 und Gate-Elektrode 412 weist gemäß diesem Ausführungsbeispiel Siliziumdioxid (SiO₂) mit einer Dicke von 10 nm auf.

Das Einspeichern bzw. Löschen des Floatinggate-Bereichs 407 erfolgt gemäß diesem Ausführungsbeispiel vom Kanalbereich 405 her durch die erste elektrische Isolationsschicht 601 hindurch. Auf Grund der geringeren Dicke der ersten elektrischen Isolationsschicht 601 im Vergleich zu einer homogenen Isolationsschicht aus Siliziumdioxid (SiO₂) mit gleicher Isolationswirkung kann die notwendige Programmier- bzw. Löschspannung auf weniger als 8 V und die benötigte Schreibzeit auf weniger als 10 ns reduziert werden.

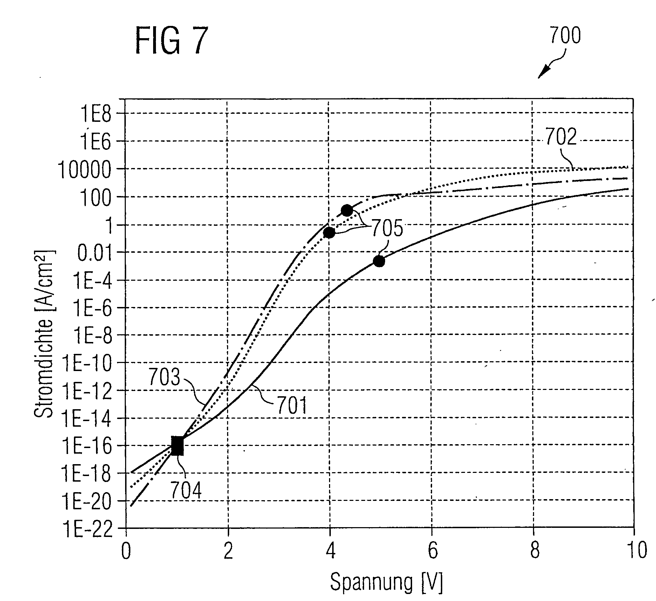

**Fig.7** zeigt ein Diagramm 700 mit Stromdichte-Spannungs-Kennlinien 701, 702, 703 für drei verschiedene Arten von elektrischen Isolationsschichten für einen Floatinggate-Feldeffekttransistor.

In dem Diagramm 700 sind die Stromdichte-Spannungs-Kennlinien dreier verschiedener als Speicherzellen verwendeter Floatinggate-Feldeffekttransistoren für eine Umgebungstemperatur von 360 K dargestellt. Die drei Kennlinien 701, 702, 703 sind derart normiert, dass bei einer an dem Floatinggate von außen versehentlich anliegenden Potentialdifferenz von 1 V die relevante Isolationsschicht zwar energetisch verspannt wird, jedoch die Stromdichte des Leckstroms einen Wert von 10⁻¹⁶ A/cm² nicht übersteigt und somit eine Haltezeit von 10 Jahren in dem Floatinggate gewährleistet ist. Folglich schneiden sich die drei Kennlinien 701, 702, 703 im Diagramm 700 bei einem Spannungswert von 1 V. Diesen Schnittpunkt identifiziert das Bezugszeichen 704 im Diagramm 700.

Die Kennlinie 701 ergibt sich für einen Floatinggate-Feldeffekttransistor, bei dem die zum Programmieren zu durchtunnelnde homogenen Isolationsschicht 5 nm dickes Siliziumdioxid (SiO₂) aufweist. Die Kennlinie 701 repräsentiert somit eine homogenen Isolationsschicht mit linearem Potentialverlauf. Die Kennlinie 702 ergibt sich für einen Floatinggate-Feldeffekttransistor, bei dem die zum Programmieren zu durchtunnelnde Isolationsschicht eine Schichtenfolge aus einer 1 nm dicken Schicht aus Siliziumdioxid (SiO₂), einer 3,8 nm dicken Schicht aus Siliziumnitrid (Si₃N₄) und einer 1 nm dicken Schicht aus Siliziumdioxid (SiO₂) aufweist. Die Kennlinie 702 repräsentiert somit eine Schichtenfolge mit einem in Fig.5b dargestellten stufenförmigen Potentialverlauf mit niedrigerer Potentialbarriere in der Mitte und weist wegen d_{EOT} = ε₂/ε₁·d eine effektiv wirksame Gesamtdicke von rund 3,9 nm auf. Die Kennlinie 703 ergibt sich für einen Floatinggate-Feldeffekttransistor, bei dem die zum Programmieren zu durchtunnelnde Isolationsschicht eine Schichtenfolge aus einer 1,2 nm dicken Schicht aus Siliziumdioxid (SiO₂), einer 12 nm dicken Schicht aus Zirkonoxid (ZrO₂) und einer 1,2 nm dicken Schicht aus Siliziumdioxid (SiO₂) aufweist. Die Kennlinie 703 repräsentiert somit ebenfalls eine Schichtenfolge mit einem in Fig.5b dargestellten stufenförmigen Potentialverlauf mit niedrigerer Potentialbarriere in der Mitte und weist wegen d_{EOT} = ε₂/ε₁·d eine effektiv wirksame Gesamtdicke von rund 4,3 nm auf.

Die Punkte 705 kennzeichnen das maximal anlegbare elektrische Feld in Höhe von 10 MV/cm. Größere elektrische Felder würden zu Leckströmen in das Halbleitersubstrat 401 führen, wodurch es zu mechanischen Beschädigungen des Halbleitersubstrats 401 kommen kann.

Das Diagramm 700 zeigt, dass bei gleicher anliegender Potentialdifferenz die elektrisch isolierende Schichtenfolge mit dem stufenförmigen Potentialverlauf mit niedrigerer Potentialbarriere in der Mitte im Vergleich zu der Isolationsschicht mit linearem Potentialverlauf eine deutlich größere Stromdichte ermöglicht, obwohl die physikalische Dicke der elektrisch isolierenden Schichtenfolge größer ist als die Dicke der Isolationsschicht mit linearem Potentialverlauf. Dies hat zur Folge, dass die benötigte Schreibzeit in einem Floatinggate-Feldeffekttransistor mit einer erfindungsgemäßen elektrisch isolierenden Schichtenfolge entsprechend reduziert werden kann.

In diesem Dokument sind folgende Veröffentlichungen zitiert:
[1] Widmann D., Mader H., Friedrich H.: "Technologie hochintegrierter Schaltungen", Kapitel 8.4, Springer Verlag, Berlin, IBSN 3-540-59357-8 (1996)
[2] DE 198 23 768 A1
[3] Nakazato K., Piotrowicz P.J.A., Hasko D.G., Ahmed H., Itoh K.: "PLED - Planar Localised Electron Devices" in IEEE Proc. IEDM97 Tech. Dig., pp. 179-182 (1997)
[4] Watanabe M., Fumayama T., Teraji T., Sakamaki N.: "CaF₂/CdF₂ Double-Barrier Resonant Tunneling Diode with High Room-Temperature Peak-to-Valley Ratio" in Jpn. J. Appl. Phys., Vol. 39, pp. L716-L719 (2000)
[5] WO 99/19913

### Bezugszeichenliste

- 100: PLED-Speicherzelle gemäß Stand der Technik
- 101: Substrat
- 102: Source-Bereich
- 103: Drain-Bereich
- 104: elektrisch isolierender Bereich
- 105: Ladungsspeicher-Bereich
- 106: Tunnelschicht
- 107: halbleitender Bereich
- 108: Elektrode
- 109: seitliche Gate-Elektrode
- 200: Resonanz-Tunneldiode gemäß Stand der Technik
- 201: n⁺-dotiertes Silizium-Substrat
- 202: erste Tunnelbarriere
- 203: Potentialtopf-Schicht
- 203a: erstes Energieniveau
- 203b: zweites Energieniveau
- 204: zweite Tunnelbarriere
- 205: elektrisch isolierende Schicht
- 206: Elektrode
- 207: elektrischer Stromfluss von dem n⁺-dotierten Silizium-Substrat 201 durch die Potentialtopf-Schicht 203 hindurch bis hinein in die Elektrode 206
- 300: Tunnelbarriere gemäß dem Stand der Technik
- 301: rechteckiger Potentialverlauf der Tunnelbarriere
- 302: Grundzustand
- 303: verspannter Zustand
- 304: stufenförmiger Potentialverlauf der Tunnelbarriere mit höchster Potentialbarriere in der Mitte
- 305: Grundzustand
- 306: verspannter Zustand
- D: Dicke der Tunnelbarriere
- U: Potentialhöhe der Tunnelbarriere
- E_{F}: Fermi-Niveau
- d: Dicke der mittleren Schicht
- d': Dicke jeder äußeren Schicht
- U': hohe Potentialbarriere der mittleren Schicht
- U": niedrige Potentialbarriere der äußeren Schichten
- eV: anliegende äußere Potentialdifferenz
- E_{F}': verspanntes Fermi-Niveau
- j: elektrischer Strom
- 307: Ladungsträgersenke
- 400: Floatinggate-Feldeffekttransistor gemäß erstem Ausführungsbeispiel der Erfindung
- 401: Halbleitersubstrat
- 402: Substratoberfläche
- 403: Source-Bereich
- 404: Drain-Bereich
- 405: Kanalbereich
- 406: erste elektrische Isolationsschicht
- 407: Floatinggate-Bereich
- 408: zweite elektrische Isolationsschicht
- 409: untere Schicht
- 410: mittlere Schicht
- 411: obere Schicht
- 412: Gate-Elektrode
- 500: stufenförmiger Potentialverlauf der zweiten elektrischen Isolationsschicht mit niedrigerer Potentialbarriere in der Mitte
- 501: Grundzustand
- 502: verspannter Zustand
- U*: hohe Potentialbarriere der äußeren Schichten
- U**: niedrige Potentialbarriere der mittleren Schicht
- 600: Floatinggate-Feldeffekttransistor gemäß zweitem Ausführungsbeispiel der Erfindung
- 601: erste elektrische Isolationsschicht
- 602: zweite elektrische Isolationsschicht
- 700: Diagramm mit Stromdichte-Spannungs-Kennlinien
- 701: Kennlinie für linearen Potentialverlauf
- 702: Kennlinie für stufenförmigen Potentialverlauf mit höherer Potentialbarriere in der Mitte
- 703: Kennlinie für stufenförmigen Potentialverlauf mit niedrigerer Potentialbarriere in der Mitte
- 704: Schnittpunkt der drei Kennlinien
- 705: Kennzeichnungspunkt des maximal anlegbaren elektrischen Feldes

## Patentansprüche

1. Floatinggate-Feldeffekttransistor
• mit einem Source-Bereich, einem Drain-Bereich und einem Kanalbereich,
• mit einer über dem Kanalbereich angeordneten ersten elektrischen Isolationsschicht,
• mit einem über der ersten elektrischen Isolationsschicht angeordneten Floatinggate-Bereich,
• mit einer über dem Floatinggate-Bereich angeordneten zweiten elektrischen Isolationsschicht, und
• mit einem über der zweiten elektrischen Isolationsschicht angeordneten Gate-Bereich,
• wobei die erste elektrische Isolationsschicht oder die zweite elektrische Isolationsschicht eine elektrisch isolierende Schichtenfolge aus drei Schichten aufweist,
• wobei die elektrisch isolierende Schichtenfolge aufweist eine untere Schicht aus einem Material mit einer ersten relativen Dielektrizitätskonstante, eine mittlere Schicht aus einem Material mit einer zweiten relativen Dielektrizitätskonstante und eine obere Schicht aus einem Material mit einer dritten relativen Dielektrizitätskonstante, und
• wobei die zweite relative Dielektrizitätskonstante größer als die erste relative Dielektrizitätskonstante sowie größer als die dritte relative Dielektrizitätskonstante ist.

2. Floatinggate-Feldeffekttransistor gemäß Anspruch 1, welcher derart eingerichtet ist, dass beim Anliegen eines elektrischen Feldes in der elektrisch isolierenden Schichtenfolge keine Ladungsträger-Akkumulation erfolgt.

3. Floatinggate-Feldeffekttransistor gemäß Anspruch 1 oder 2, bei dem die untere Schicht und die obere Schicht eine zwischen 0,5 eV und 1,5 eV höhere Potentialbarriere als die mittlere Schicht aufweisen.

4. Floatinggate-Feldeffekttransistor gemäß einem der Ansprüche 1 bis 3,
bei dem die erste relative Dielektrizitätskonstante und die dritte relative Dielektrizitätskonstante jeweils einen Wert im Bereich zwischen 1 und 10 aufweisen, und bei dem die zweite relative Dielektrizitätskonstante einen Wert im Bereich zwischen 10 und 25 aufweist.

5. Floatinggate-Feldeffekttransistor gemäß einem der Ansprüche 1 bis 4,
bei dem in der elektrisch isolierenden Schichtenfolge die untere Schicht und die obere Schicht aus dem gleichen Material hergestellt sind.

6. Floatinggate-Feldeffekttransistor gemäß einem der Ansprüche 1 bis 5,
bei dem die untere Schicht sowie die obere Schicht der elektrisch isolierenden Schichtenfolge jeweils eine Dicke im Bereich von 0,5 nm bis 2 nm aufweisen, und bei dem die mittlere Schicht der elektrisch isolierenden Schichtenfolge eine Dicke im Bereich von 5 nm bis 10 nm aufweist.

7. Floatinggate-Feldeffekttransistor gemäß einem der Ansprüche 1 bis 6,
bei dem die untere Schicht sowie die obere Schicht der elektrisch isolierenden Schichtenfolge jeweils Siliziumdioxid sowie eine Dicke von 1 nm aufweisen, und bei dem die mittlere Schicht der elektrisch isolierenden Schichtenfolge Zirkonoxid sowie eine Dicke von 6 nm aufweist.
